(19)

Europäisches Patentamt
European Patent Office
Office européen des brevets

(11) **EP 4 328 820 A1**

(12) **EUROPEAN PATENT APPLICATION**
published in accordance with Art. 153(4) EPC

(43) Date of publication:
**28.02.2024 Bulletin 2024/09**

(21) Application number: **23806157.6**

(22) Date of filing: **13.04.2023**

(51) International Patent Classification (IPC):
**G06Q 10/06** (2023.01)       **G06F 30/20** (2020.01)

(86) International application number:
**PCT/CN2023/088199**

(87) International publication number:
**WO 2023/231606 (07.12.2023 Gazette 2023/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.05.2022   CN 202210602602**

(71) Applicants:
• **Foshan Midea Chungho Water Purification Equipment Co., Ltd.**
  **Foshan, Guangdong 528311 (CN)**
• **Midea Group Co., Ltd.**
  **Foshan, Guangdong 528311 (CN)**

(72) Inventors:
• **QING, Pu**
  **Foshan**
  **Guangdong 528311 (CN)**
• **ZHANG, Bo**
  **Foshan**
  **Guangdong 528311 (CN)**

• **HAO, Zhipeng**
  **Foshan**
  **Guangdong 528311 (CN)**
• **HU, Chenghuan**
  **Foshan**
  **Guangdong 528311 (CN)**
• **GONG, Ziming**
  **Foshan**
  **Guangdong 528311 (CN)**
• **HUANG, Rensheng**
  **Foshan**
  **Guangdong 528311 (CN)**
• **ZHENG, Yuedong**
  **Foshan**
  **Guangdong 528311 (CN)**
• **LIAO, Yumin**
  **Foshan**
  **Guangdong 528311 (CN)**

(74) Representative: **Whitlock, Holly Elizabeth Ann et al**
  **Maucher Jenkins**
  **Seventh Floor Offices**
  **Artillery House**
  **11-19 Artillery Row**
  **London SW1P 1RT (GB)**

(54) **PERFORMANCE TESTING METHOD FOR WATER SOFTENING DEVICE**

(57)     A method for detecting the performance of the water softening device includes: obtaining a correspondence between a water temperature and a pressure drop of a target flow line; determining a target pressure drop corresponding to a current test water temperature based on the correspondence between the water temperature and the pressure drop of the target flow line; and determining a performance detection result based on a numerical relationship between an actual pressure drop and the target pressure drop, where the target flow line is a flow line between a water inlet end and a water outlet end of the water softening device, and the actual pressure drop is a pressure drop of the target flow line under the current test water temperature.

A correspondence between a water temperature and a pressure drop of a target flow line is obtained — S1

A target pressure drop corresponding to a current test water temperature is determined based on the correspondence between the water temperature and the pressure drop of the target flow line — S2

A performance detection result is determined based on a numerical relationship between an actual pressure drop and the target pressure drop — S3

FIG. 1

EP 4 328 820 A1

**Description**

**CROSS-REFERENCE TO RELATED APPLICATION**

The present application is based on and claims priority to Chinese Patent Application No. 202210602602.9, filed on May 30, 2022, which is hereby incorporated by reference in its entirety.

**TECHNICAL FIELD**

The present disclosure relates to the field of water softening devices, and in particular, to a method and an apparatus for detecting performance of a water softening device, an electronic device, and a storage medium.

**BACKGROUND**

A water softener is a household appliance converting hard tap water into soft water, which can improve the quality of household water. Its principle is to exchange calcium ions and magnesium ions in the tap water with an exchange resin containing sodium cations, and absorb excess calcium ions and magnesium ions in the tap water to soften the tap water.

A water softening device needs to meet a certain performance condition when it leaves a factory. For example, a flow rate (pressure drop) of water in a flow line in the water softening device at a certain temperature must meet a specified requirement. In a laboratory test environment, during the development process of the water softener, a water temperature for testing and a temperature of test environment changes seasonally, which affects the flow rate of the water, and affects verification of the performance of the water softening device. The performance of the water softening device can only be verified and tested in the case that a large amount of money is invested to control the water temperature to be within a certain range. In the case that there is a lack of a temperature control device to control the water temperature, the performance of the water softening device cannot be completely and accurately verified.

**SUMMARY**

The present disclosure aims to solve at least one of the problems existing in the related art. Therefore, the present disclosure provides a method for detecting performance of a water softening device, by which the performance of the water softening device can be completely and accurately verified without using a temperature control device.

The present disclosure further provides a device for detecting performance of a water softening device.

The present disclosure further provides an electronic device.

The present disclosure further provides a storage medium.

The present disclosure further provides a computer program product.

A method for detecting performance of a water softening device provided by an embodiment of the present disclosure includes:

obtaining a correspondence between a water temperature and a pressure drop of a target flow line;
determining a target pressure drop corresponding to a current test water temperature based on the correspondence between the water temperature and the pressure drop of the target flow line; and
determining a performance detection result based on a numerical relationship between an actual pressure drop and the target pressure drop,
where the target flow line is a flow line between a water inlet end and a water outlet end of the water softening device, and the actual pressure drop is a pressure drop of the target flow line under the current test water temperature.

According to the method for detecting the performance of the water softening device provided by the embodiment of the present disclosure, by obtaining the correspondence between the water temperature and the pressure drop of the target flow line, the corresponding target pressure drop can be matched to the test environment at any temperature, and the performance of the flow line of the water softening device can be completely and accurately detected and verified.

According to an embodiment of the present disclosure, obtaining the correspondence between the water temperature and the pressure drop of the target flow line includes:

obtaining the correspondence between the water temperature and the pressure drop of the target flow line by fitting a pre-stored temperature-pressure correspondence table of the target flow line.

According to the method for detecting the performance of the water softening device provided by the embodiment of the present disclosure, the correspondence between the water temperature and the pressure drop of the target flow line is obtained by fitting a pre-stored standard temperature-pressure correspondence table, which can improve the accuracy of the obtained correspondence between the water temperature and the pressure drop of the target flow line, and the performance verification accuracy of the flow line of the water softening device is improved.

According to an embodiment of the present disclosure, obtaining the correspondence between the water temperature and the pressure drop of the target flow line by fitting the pre-stored temperature-pressure correspondence table of the target flow line includes:

obtaining a linear regression equation of a water temperature and a pressure drop based on a plurality of reference water temperatures and a plurality of reference pressure drop corresponding to the plurality of reference water temperatures in the temperature-pressure correspondence table; and

determining the correspondence between the water temperature and the pressure drop of the target flow line based on the linear regression equation,

where the reference pressure drop is the pressure drop of the target flow line at a corresponding reference water temperature.

According to the method for detecting the performance of the water softening device provided by the embodiment of the present disclosure, the linear regression equation of the water temperature and the pressure drop is obtained by calculating based on the reference water temperature and the corresponding reference pressure drop in the temperature-pressure correspondence table, and the linear regression equation is taken as the correspondence between the water temperature and the pressure drop of the target flow line, which further improves the performance verification accuracy of the flow line of the water softening device.

According to an embodiment of the present disclosure, determining the performance detection result based on the numerical relationship between the actual pressure drop and the target pressure drop includes:

determining, in accordance with a determination that an absolute value of a difference between the actual pressure drop and the target pressure drop is greater than a preset threshold, a performance detection result is determined as a failure in the pressure drop performance.

According to the method for detecting the performance of the water softening device provided by the embodiment of the present disclosure, the pressure drop performance of the water softening device is determined as a failure in the case that the actual pressure drop is far from the target pressure drop, which further improves the performance verification accuracy of the flow line of the water softening device.

According to an embodiment of the present disclosure, after determining the performance detection result based on the numerical relationship between the actual pressure drop and the target pressure drop, the method further includes:

adjusting a simulation model of the target flow line based on the performance detection result,

where the adjusting the simulation model of the target flow line includes at least one of the following:

adjusting the simulation model of the target flow line by adjusting a flow resistance parameter of the target flow line; or

adjusting the simulation model of the target flow line by adjusting a size parameter of a water inlet pipe of the target flow line.

According to the method for detecting the performance of the water softening device provided by the embodiment of the present disclosure, the simulation model of the target flow line is adjusted by adjusting the flow resistance parameter and/or the size parameter of the water inlet pipe, and an optimization process of the flow line performance can be intuitively perceived during a test process, which improves efficiency of performance verification of the flow line of the water softening device.

According to an embodiment of the present disclosure, adjusting the simulation model of the target flow line based on the performance detection result includes:

performing at least one of the following in accordance with a determination that the actual pressure drop is greater than the target pressure drop:

adjusting the simulation model of the target flow line by decreasing the flow resistance parameter of the target flow line; and

adjusting the simulation model of the target flow line by increasing the size parameter of the water inlet pipe of the target flow line;

performing at least one of the following in accordance with a determination that the actual pressure drop is less than the target pressure drop:

adjusting the simulation model of the target flow line by increasing the flow resistance parameter of the target flow line; or

adjusting the simulation model of the target flow line by decreasing the size parameter of the water inlet pipe of the target flow line.

According to the method for detecting the performance of the water softening device provided by the embodiment of the present disclosure, in the case that the actual pressure drop is too large, the simulation model of the target flow line is adjusted by decreasing the flow resistance parameter of the target flow line and/or increasing the size parameter of the water inlet pipe of the target flow line; and in the case that the actual pressure drop is too small, the simulation model of the target flow line is adjusted by increasing the flow resistance parameter of the target flow line and/or reducing the size parameter of the water inlet pipe of the target flow line, and the target flow line of the water softening device is accurately verified and optimized.

A device for detecting performance of a water softening device provided by an embodiment of the present disclosure includes:

an obtaining module, configured to obtain a correspondence between a water temperature and a pressure drop of a target flow line;

a determining module, configured to determine a target pressure drop corresponding to a current test water temperature based on the correspondence between the water temperature and the pressure drop of the target flow line; and

a detecting module, used for determining a performance detection result based on a numerical relationship between an actual pressure drop and the target pressure drop,

where the target flow line is a flow line between a water inlet end and a water outlet end of the water softening device, and the actual pressure drop is a pressure drop of the target flow line under the current test water temperature.

An electronic device provided by an embodiment of the present disclosure includes a memory, a processor and a computer program stored on the memory and is executable on the processor, where when executing the computer program, the processor performs any one of the above-mentioned method for detecting the performance of the water softening device.

A non-transitory computer-readable storage medium provided by an embodiment of the present disclosure having a computer program stored thereon, where when executed by a processor, the computer program performs any one of the above-mentioned method for detecting the performance of the water softening device.

A computer program product provided by an embodiment of the present disclosure includes a computer program, where when executed by a processor, the computer program performs any one of the above-mentioned method for detecting the performance of the water softening device.

One or more of the above solutions in the embodiments of the present disclosure have at least one of the following effects.

By obtaining the correspondence between the water temperature and the pressure drop of the target flow line, the corresponding target pressure drop can be matched to the test environment at any temperature, and the performance of the flow line of the water softening device can be completely and accurately detected and verified.

Additional aspects and advantages of the present disclosure will be set forth in part in the description which follows and, in part, will be apparent from the description, or may be learned by practice of the presented disclosure.

## BRIEF DESCRIPTION OF DRAWINGS

In order to clearly illustrate the solutions according to the present application or the related art, the accompanying drawings used in the description of the embodiments of the present application or the related art are briefly introduced below. It should be noted that the drawings in the following description are of only part embodiments of the present application. For those of ordinary skill in the art, other drawings can also be obtained according to these drawings without creative efforts.

FIG. 1 is a schematic flow chart of a method for detecting performance of a water softening device according to an embodiment of the present disclosure;

FIG. 2 is a schematic diagram of an output curve of a sensor according to an embodiment of the present disclosure;

FIG. 3 is a first schematic diagrams of a fitting curve of temperature and pressure drop according to an embodiment of the present disclosure;

FIG. 4 is a second schematic diagram of a fitting curve of temperature and pressure drop according to an embodiment of the present disclosure;

FIG. 5 is a schematic structural diagram of a device for detecting performance of a water softening device according to an embodiment of the present disclosure; and

FIG. 6 is a schematic structural diagram of an electronic device according to an embodiment of the present disclosure.

## DETAILED DESCRIPTION OF THE EMBODIMENTS

Embodiments of the present disclosure are further described in detail below with reference to the drawings and embodiments. The following embodiments are intended to illustrate the disclosure, but are not intended to limit the scope of the disclosure.

It should be noted that with the improvement of living standards, people pay more and more attention to household water use. There are more and more water softeners on the market now. A water softener can replace calcium ions and magnesium ions in the water with sodium ions, and softening high hardness water into soft water, which prolongs the service life of a back-end water-related device, and can be used for beauty, skin care, clothing care, etc.

In order to make a water softening device operate and meet its performance, necessary physical conditions are a temperature, a pressure and a flow rate. Traditional water softeners currently on the market only have a flow sensor to monitor the flow rate, without real-time monitoring of the temperature and the pressure, which are two key physical conditions. In a laboratory test environment, during the development process of the water softener, a water temperature for testing and a temperature of test environment changes seasonally, which affects the flow rate of the water, and affects verification of the performance of the water softening device. Investing in a set of devices that can control the temperature and meet a hardness standard can cost millions, and companies are often unwilling to invest in a such expensive temperature control device, resulting in a lack of completeness and accuracy when verifying performance of the water softener in a laboratory.

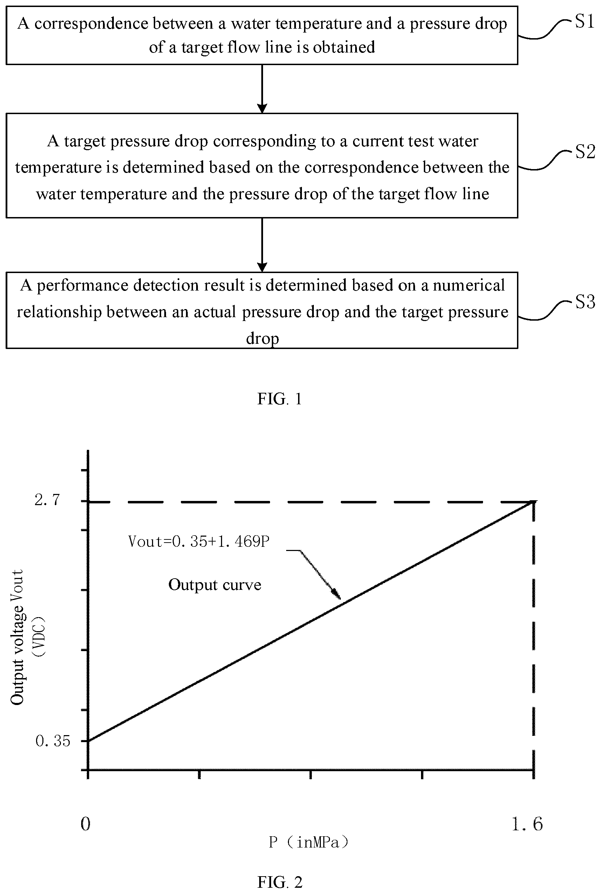

Referring to FIG. 1, an embodiment of the present disclosure provides a method for detecting performance of a water softening device, which may include the following blocks.

Block S1: a correspondence between a water temperature and a pressure drop of a target flow line is obtained.

Block S2: a target pressure drop corresponding to a current test water temperature is determined based on the correspondence between the water temperature and the pressure drop of the target flow line.

Block S3: a performance detection result is determined based on a numerical relationship between an actual pressure drop and the target pressure drop.

The target flow line is a flow line between a water inlet end and a water outlet end of the water softening device, and the actual pressure drop is a pressure drop of the target flow line under the current test water temperature.

It can be understood that the pressure drop is equivalent to water pressure loss in a pipeline. For example, for a target pipeline between a water inlet and a water outlet of the water softener, under a constant condition (an inlet water velocity is fixed and the temperature is fixed), a difference between a water pressure measured near the water inlet and a water pressure measured from the water outlet is a pressure drop under the constant condition. Since the pressure drop of the flow line of the water softener affects water usage of a household water main pipeline of a user, in order to minimize an impact of the usage of the water softener on the water usage of the main pipeline, the pressure drop of the flow line of the water softening device is the smaller the better within a certain range theoretically. In addition, when considering user experience, a water output volume of the water softener needs to be controlled within a certain range, that is, neither too high nor too small. A better reference of the water output volume can be obtained through a large number of user test verifications. A water pressure corresponding to the water outlet can be calculated based on the reference of the water output volume, and a standard pressure drop between the inlet and the outlet of the water softener can be determined.

It should be noted that at a rated flow rate, due to different fluidities of water at different temperatures, standard pressure drops corresponding to different temperatures are also different. Therefore, in order to verify whether the water output volume of the water softener meets a set standard, it is necessary to verify the pressure drop of the flow line at different temperatures. In the embodiment of the present disclosure, standard pressure drops corresponding to different temperatures at the rated flow rate is first obtained, and the standard pressure drop can be determined by performing a plurality of tests and verifications in advance. Based on these different temperatures and different standard pressure drops, the correspondence between the water temperature and the pressure drop of the target flow line can be determined, the current test water temperature in the laboratory (that is, a temperature of the water body used to detect the performance of the flow line of the water softener) is measured, and the target pressure drop at the current test water temperature can be obtained by matching the current test water temperature with a temperature-pressure correspondence relationship (that is, the correspondence between the water temperature and the pressure drop of the target flow line). That is, when the target pipeline is tested at the rated flow rate by using the water body with the current test water temperature, the pressure drop should be taken as a basis for determining whether it has passed the test verification. Under the current test water temperature, water is passed into the water softening device at the rated flow rate, and the actual pressure drop of the target pipeline (that is, a difference between a water pressure of the water inlet and a water pressure of the water outlet) is measured, to determine the performance detection result based on the numerical relationship between the actual pressure drop and the target pressure drop. For example, if it is measured that the actual pressure drop is higher than the target pressure drop by a certain value, it indicates that the performance detection of the target pipeline of the water softening device is determined as a failure.

In the method for detecting the performance of the water softening device provided by the embodiment of the present disclosure, by obtaining the correspondence between the temperature and the pressure drop, the corresponding target pressure drop can be matched to the test environment at any temperature, and the performance of the flow line of the water softening device can be completely and accurately detected and verified.

In an embodiment, block S1 includes:

S11: the correspondence between the water temperature and the pressure drop of the target flow line is obtained by fitting a pre-stored temperature-pressure correspondence table of the target flow line.

In the embodiment of the present disclosure, the correspondence between the water temperature and the pressure drop of the target flow line can be obtained by fitting the pre-stored temperature-pressure correspondence table of the target flow line. The temperature-pressure correspondence table records a plurality of temperatures and corresponding reference pressure drops, and the reference pressure drop can be calibrated through repeated experimental verification at the rated flow rate. First, temperatures and calibrated pressure drops are marked in a coordinate system, and then marked points are fitted to obtain the correspondence between the water temperature and the pressure drop of the target flow line. It can be understood that fitting refers to connecting a series of points on a plane using a smooth curve. Since there are countless possibilities for the curve, there are various fitting modes. Commonly used fitting modes include least squares curve fitting mode, etc. Fitting, interpolation and approximation are the three basic tools of numerical analysis. In a popular sense, their difference is that: fitting refers to approaching points in a known point sequence as a whole interpolation refers to completely passing through points in a known point sequence; and approximation refers to constructing a function that gets infinitely close to a known curve or a known point sequence through an approximation manner.

In the method for detecting the performance of the water softening device provided by the embodiment of the present disclosure, the corresponding target pressure drop at any temperature can be obtained by fitting numerical values of the temperature-pressure correspondence table, without using an expensive temperature control device to control the test water temperature to be a certain temperature to obtain the corresponding target pressure drop from the temperature-pressure correspondence table, so as to completely and accurately verify the performance of the flow line of the water softener without using the temperature control device.

In an embodiment, S11 further includes:

S111: a linear regression equation of a water temperature and a pressure drop is obtained based on a plurality of reference water temperatures and a plurality of reference pressure drop corresponding to the plurality of reference water temperatures in the temperature-pressure correspondence table; and

the correspondence between the water temperature and the pressure drop of the target flow line is determined based on the linear regression equation,

where the reference pressure drop is the pressure drop of the target flow line at a corresponding reference water temperature.

It should be noted that based on multiple sets of data with certain rules, a corresponding functional relationship expression can be obtained based on independent variables and dependent variables of the multiple sets of data. In the embodiment of the present disclosure, a plurality of reference water temperatures in the temperature-pressure correspondence table can be used as independent variables, and reference pressure drops corresponding to each reference water temperature can be used as dependent variables, and its linear regression equation can be obtained, a linear fitting is performed on the temperature-pressure correspondence table, and then the corresponding target pressure drop at any temperature is obtained through the linear regression equation.

In the method for detecting the performance of the water softening device provided by the embodiment of the present disclosure, the corresponding linear regression equation is calculated based on numerical values of the temperature-pressure correspondence table, the corresponding target pressure drop at any temperature is obtained without using an expensive temperature control device to control the test water temperature to be a certain temperature to obtain the corresponding target pressure drop from the temperature-pressure correspondence table, so as to completely and accurately verify the performance of the flow line of the water softener without using the temperature control device.

In an embodiment, in block S3,

a performance detection result is determined as a failure in the pressure drop performance in accordance with a determination that an absolute value of a difference between the actual pressure drop and the target pressure drop is greater than a preset threshold.

It should be noted that since the pressure drop of the flow line of the water softener affects the water usage of a household water main pipeline of a user, in order to minimize the impact of the usage of the water softener on the water usage of the main pipeline, the pressure drop of the flow line of the water softening device is the smaller the better within a certain range theoretically. In addition, when considering user experience, a water output volume of the water softener needs to be controlled within a certain range. If the water output volume is too high or too low, it will cause a decrease in the user experience. A better reference of the water output volume can be obtained through a large number of user test verifications. A water pressure corresponding to the water outlet can be calculated based on the reference of the water output volume, and the target pressure drop between the inlet and the outlet of the water softener can be determined. In the embodiment of the present disclosure, the target pressure drop corresponding to the rated flow rate and a current test temperature is first obtained, the actual pressure drop of the flow line of the water softener is collected and calculated during a test process, and the performance detection result is determined by comparing a difference between the actual pressure drop and the target pressure drop with the preset threshold. It can be understood that if the difference between the actual pressure drop and the target pressure drop is greater than the threshold, it means that the actual pressure drop at the rated flow rate and the current test temperature is too large or too small, resulting in a poor user experience and it is determined as a failure in the pressure drop performance and does not meet a product requirement.

In the method for detecting the performance of the water softening device provided by the embodiment of the present disclosure, the performance detection of pressure drop is determined as a failure in accordance with a determination that the actual pressure drop is far from the target pressure drop, the performance verification accuracy of the flow line of the water softening device is further improved.

In an embodiment, after block S3, the method may further include:

S4: adjusting a simulation model of the target flow line based on the performance detection result,
where the adjusting the simulation model of the target flow line includes at least one of the following:

adjusting the simulation model of the target flow line by adjusting a flow resistance parameter of the target flow line; or
adjusting the simulation model of the target flow line by adjusting a size parameter of a water inlet pipe of the target flow line.

It should be noted that the performance detection result can include information about whether the pressure drop performance detection is determined as a failure or, as well as information about whether the pressure drop is too large or too small. A purpose of adjusting and optimizing the simulation model of the target flow line can be achieved based on the performance detection result. It can be understood that the pressure drop of the target flow line reflects the pressure loss between the inlet and the outlet of the flow line. If the actual pressure drop is too large, it means that the pressure loss of the flow line is too large, which will cause large effect on the water usage of the main pipeline of the user. The pressure drop needs to be reduced to meet a performance requirement. Accordingly, if the actual pressure drop is too small, it means that the pressure loss of the flow line is too small, which will cause the water output volume of the water softener being too large and affect the user experience. The pressure drop needs to be increased to meet a performance requirement. It should be noted that the pressure drop of the flow line is related to the flow resistance inside the water softener and thickness of the water inlet pipe. The pressure drop can be adjusted by adjusting the flow resistance parameter of the target flow line and/or the size parameter of the water inlet pipe.

In the method for detecting the performance of the water softening device provided by the embodiment of the present disclosure, by adjusting the simulation model of the target flow line through adjusting the flow resistance parameter and/or the size parameter of the water inlet pipe, and an optimization process of the flow line performance can be intuitively perceived during a test process, efficiency of performance verification of the flow line of the water softening device is improved.

In an embodiment, in step S4,

at least one of the following is performed in accordance with a determination that that the actual pressure drop is greater than the target pressure drop:
adjusting the simulation model of the target flow line by decreasing the flow resistance parameter of the target flow line; or
adjusting the simulation model of the target flow line by increasing the size parameter of the water inlet pipe of the target flow line;
at least one of the following is performd in accordance with a determination that the actual pressure drop is less than the target pressure drop:

adjusting the simulation model of the target flow line by increasing the flow resistance parameter of the target flow line; or

adjusting the simulation model of the target flow line by decreasing the size parameter of the water inlet pipe of the target flow line.

It should be noted that when the performance detection of pressure drop is determined as a failure, the flow resistance of the target flow line or the size parameter of the water inlet pipe needs to be adjusted. A specific parameter adjustment scheme can be further determined based on the numerical relationship between the actual pressure drop and the target pressure drop. It can be understood that the pressure drop of the flow line is related to the flow resistance inside the water softener and the thickness of the water inlet pipe. In some embodiments, when the size parameter of water inlet pipe is fixed, the greater the flow resistance of the flow line, the greater the pressure drop of the flow line. When the flow resistance parameter of the flow line is fixed, the larger the water inlet pipe is, the smaller the pressure drop of the flow line is. The specific parameter adjustment scheme can be determined based on the above relationship between the pressure drop of the flow line, the flow resistance parameter and the water inlet pipe size. After determining the adjustment scheme, a parameter can be adjusted based on a preset fixed value, or a specific adjustment value can be determined based on a specific difference between the actual pressure drop and the target pressure drop.

In the method for detecting the performance of the water softening device provided by the embodiment of the present disclosure, when the actual pressure drop is too large, the simulation model of the target flow line is adjusted by decreasing the flow resistance parameter of the target flow line and/or increasing the size parameter of the water inlet pipe of the target flow line; and when the actual pressure drop is too small, the simulation model of the target flow line is adjusted by increasing the flow resistance parameter of the target flow line and/or reducing the size parameter of the water inlet pipe of the target flow line, and the target flow line of the water softening device is accurately verified and optimized.

Referring to FIG. 2 to FIG. 4. based on the above solutions, in order to better understand the method for detecting the performance of the water softening device provided by the embodiment of the present disclosure, specific examples are listed below for detailed description.

In an embodiment of the present disclosure, an integrated temperature and pressure sensor can be installed in a water path with a control valve to detect the water temperature and the water pressure in the flow line of the water softener in real time, and information about the water temperature and the water pressure can be transmitted to the user through an APP (application program) simultaneously. In addition, a six sigma tool "minitab normal distribution plot" can be used to calculate a water temperature fitting curve based on an impact of a collected water temperature on the flow rate.

Table 1 is a temperature-pressure correspondence table at rated flow rate.

a. a bypass valve or a mixing valve is closed, a nominal flow rate is measured after a water softener automatically regenerates, and the rated flow rate is determined.
b. the water softener is connected to a hard water supply with a pressure of 400 kPa.
c. the pressure drop of the water softener at different flow rates is measured, and the water temperature is measured simultaneously.
d. the nominal flow rate refers to a flow rate when the measured pressure drop and the measured water temperature are equal to a pressure drop and a water temperature given in the below temperature-pressure correspondence tables; and when the water temperature exceeds a range given in table 1, the nominal flow rate needs to be calculated by using a temperature-pressure fitting formula.

It can be understood that in addition to correspondences between the water temperature and the pressure drop listed in table 1, different correspondences between the water temperature and the pressure drop can be obtained at other preset rated flow rates.

Table 1

| Water temperature (°C) | Pressure drop corresponding to a rated flow rate (kPa) |
|---|---|
| 5 | 135 |
| 6 | 132 |
| 7 | 127 |
| 8 | 122 |
| 9 | 119 |
| 10 | 115 |

(continued)

| Water temperature (°C) | Pressure drop corresponding to a rated flow rate (kPa) |
|---|---|
| 11 | 111 |
| 12 | 109 |
| 13 | 105 |
| 14 | 103 |
| 15 | 100 |
| 16 | 97 |
| 17 | 95 |
| 18 | 93 |
| 19 | 91 |
| 21 | 86 |
| 22 | 85 |
| 23 | 83 |
| 24 | 81 |
| 25 | 79 |

Temperatures and pressure values of the flow line can be obtained through the integrated temperature and pressure sensor.

Based on changes in voltage under different pressures, the pressure in a to-be-detected pipeline is logically calculated. As an example, parameter information of the integrated temperature and pressure sensor can be as shown in table 2.

Table 2

| Measuring range | 0~16 Bar |
|---|---|
| Power supply | DC 3.3V |
| Output | 0.35-2.7 V DC |
| Operating temperature | -20°~85 °C |
| Accuracy level | 2% FS |
| Installation torque | Less than 30N·m |
| Overload pressure | 150% |
| Precision of temperature | 2% |

The integrated temperature and pressure sensor can logically calculate and detect the temperature and the pressure of water in the to-be-detected pipeline based on voltage changes under different pressures. A relationship between an output voltage of the sensor and a pressure can be indicated by the output curve in FIG. 2. An expression of an output curve can be expressed as: $V_{out} = 0.35 + 1.469P$, where $V_{out}$ represents the output voltage, and P represents the corresponding pressure. Therefore, the correspondence between the output voltage and the pressure value can be as shown in Table 3.

Table 3

| P(inMPa) | 0 | 0.1 | 0.2 | 0.3 | 0.4 | 0.5 | 0.6 | 0.7 | 0.8 | 0.9 | 1.0 | 1.1 | 1.2 | 1.3 | 1.4 | 1.5 | 1.6 |
|---|---|---|---|---|---|---|---|---|---|---|---|---|---|---|---|---|---|
| Vout | 0.35 | 0.49 | 0.64 | 0.79 | 0.93 | 1.08 | 1.23 | 1.38 | 1.52 | 1.67 | 1.82 | 1.96 | 2.11 | 2.26 | 2.4 | 2.55 | 2.7 |

In the embodiment of the present disclosure, based on known temperatures and pressure drops in the temperature-pressure correspondence table, a regression formula for the water temperature and the pressure drop can be calculated by using the six sigma tool "minitab normal distribution plot". Relevant help can be obtained by pressing F1 key in the minitab tool. A Pareto diagram of a component and a Pareto diagram of a model are combined to perform regression analysis. A regression equation of a correspondence between the pressure drop (kPa) corresponding to the rated flow rate and the water temperature (°C) is as follows:

the pressure drop corresponding to the rated flow rate (kPa) = 143.9-2.743×the water temperature (°C);

an output analysis result is as follows:

$$S=2.72204R\text{-}Sq=97.7\%R\text{-}Sq \text{ (adjusted)}=97.5\%;$$

variance analysis:

| source | degrees of Freedom | SS | MS | F | P |
| --- | --- | --- | --- | --- | --- |
| regression | 1 | 5595.43 | 5595.43 | 755.17 | 0.000 |
| error | 18 | 133.37 | 7.41 | | |
| total | 19 | 5728.80 | | | |

where SS is a sum of squares; MS is a sum of mean squares obtained by SS/dF; F is an F statistic, such as F (part) =ms (part)/ms (part× oper) in interaction analysis; and P is significant probability of significance used to determine significance.

Fitting line: a polynomial regression analysis is performed on the pressure drop (kPa) and the water temperature (°C) corresponding to the rated flow rate, and the regression equation is obtained as follows:

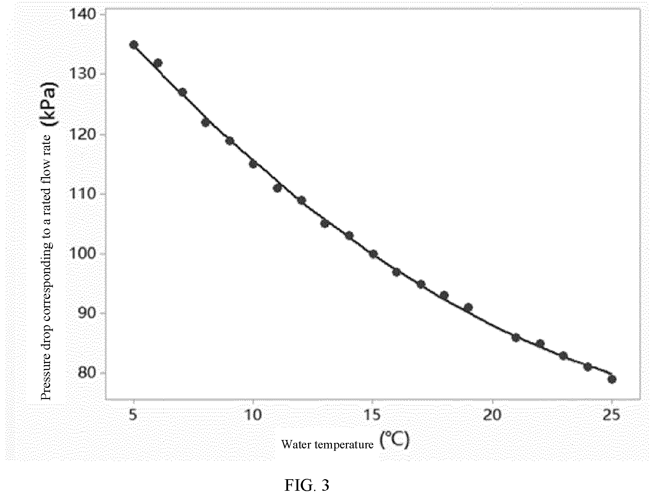

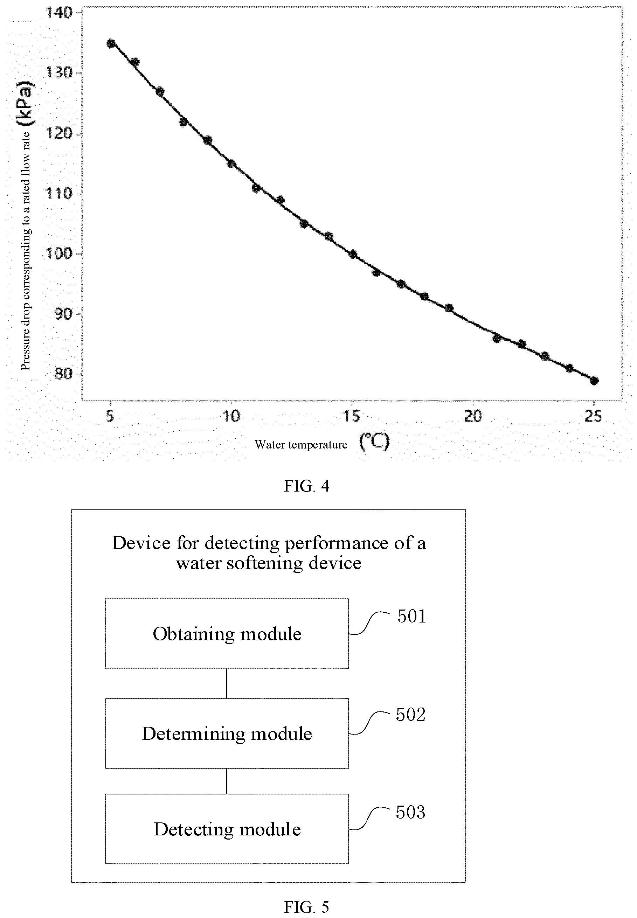

equation 1: the pressure drop corresponding to the rated flow rate (kPa) = 158.1-5.005×the water temperature (°C) + 0.07521×the water temperature (°C)^2; and a fitting curve of equation 1 is shown in FIG. 3; and

equation 2: the pressure drop corresponding to the rated flow rate (kPa) = 163.8-6.481×the water temperature (°C)+0.1848×the water temperature (°C)^2-0.002441×the water temperature (°C)^3; and a fitting curve of equation 2 is shown in FIG. 4.

A second order fitting of equation 1 and a third order fitting of equation 2 are both very good, and both of them reach a 95% confidence interval according to the six sigma quality control standard. These two equations can be used as correspondences of the water temperature and the pressure drop.

Compared with the related art, in the embodiment of the present disclosure, the linear regression equation of the water temperature and the pressure drop is calculated and taken as a basis for verifying the pressure drop performance of the flow line of the water softening device, and the performance of the water softening device is completely and accurately verified without using the temperature control device.

Referring to FIG. 5, a device for detecting performance of the water softening device provided by an embodiment of the present disclosure includes:

an obtaining module 501, configured to obtain a correspondence between a water temperature and a pressure drop of a target flow line;

a determining module 502, configured to determine a target pressure drop corresponding to a current test water temperature based on the correspondence between the water temperature and the pressure drop of the target flow line; and

a detecting module 503, configured to determine a performance detection result based on a numerical relationship between an actual pressure drop and the target pressure drop,

where the target flow line is a flow line between a water inlet end and a water outlet end of the water softening device, and the actual pressure drop is a pressure drop of the target flow line under the current test water temperature.

In an embodiment, the obtaining module 501 is configured to:

obtain the correspondence between the water temperature and the pressure drop of the target flow line by fitting a pre-stored temperature-pressure correspondence table of the target flow line.

In an embodiment, the obtaining module 501 is configured to:

obtain a linear regression equation of a water temperature and a pressure drop based on a plurality of reference water temperatures and a plurality of reference pressure drop corresponding to the plurality of reference water temperatures in the temperature-pressure correspondence table; and
determine the correspondence between the water temperature and the pressure drop of the target flow line based on the linear regression equation,
where the reference pressure drop is the pressure drop of the target flow line at a corresponding reference water temperature.

In an embodiment, the detecting module 503 is configured to:
determine, in accordance with a determination that an absolute value of a difference between the actual pressure drop and the target pressure drop is greater than a preset threshold, a performance detection result is determined as a failure in the pressure drop performance.

In an embodiment, the device for detecting the performance of the water softening device further includes an adjusting module, which is configured to:

adjust a simulation model of the target flow line based on the performance detection result,
where
the simulation model of the target flow line is adjusted by adjusting a flow resistance parameter of the target flow line; and
the simulation model of the target flow line is adjusted by adjusting a size parameter of a water inlet pipe of the target flow line.

In an embodiment, the adjusting module is configured to:
perform at least one of the following in accordance with a determination that the actual pressure drop is greater than the target pressure drop:

adjusting the simulation model of the target flow line by decreasing the flow resistance parameter of the target flow line; and
adjusting the simulation model of the target flow line by increasing the size parameter of the water inlet pipe of the target flow line;
perform at least one of the following in accordance with a determination that the actual pressure drop is less than the target pressure drop:
adjusting the simulation model of the target flow line by increasing the flow resistance parameter of the target flow line; and
adjusting the simulation model of the target flow line by decreasing the size parameter of the water inlet pipe of the target flow line.

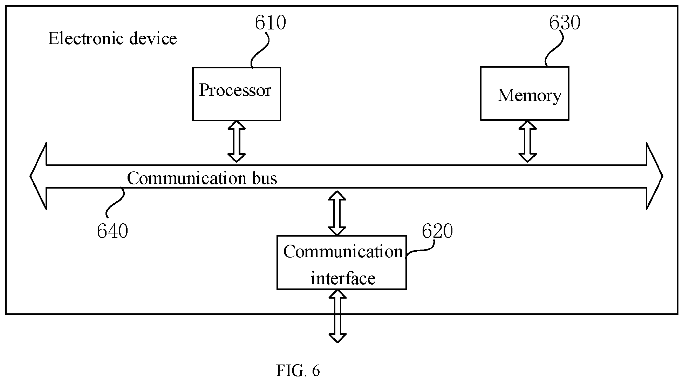

FIG. 6 illustrates a schematic diagram of a physical structure of an electronic device. As shown in FIG. 6, the electronic device may include: a processor 610, a communication interface 620, a memory 630 and a communication bus 640. The processor 610, the communication interface 620 and the memory 630 communicate with each other through the communication bus 640. The processor 610 can invoke logical instructions in the memory 630 to perform the following method, including the following blocks.

Block S1: obtaining a correspondence between a water temperature and a pressure drop of a target flow line.

Block S2: a target pressure drop corresponding to a current test water temperature is determined based on the correspondence between the water temperature and the pressure drop of the target flow line.

Block S3: a performance detection result is determined based on a numerical relationship between an actual pressure drop and the target pressure drop.

The target flow line is a flow line between a water inlet end and a water outlet end of the water softening device, and the actual pressure drop is a pressure drop of the target flow line under the current test water temperature.

In addition, the above-mentioned logical instructions in the memory 630 can be implemented in the form of software functional units and can be stored in a computer-readable storage medium when sold or used as an independent product. Based on this understanding, the solution of the present disclosure is essentially or the part that contributes to the relevant technology or the part of the solution can be embodied in the form of a software product. The computer software product is stored in a storage medium and includes several instructions used to cause a computer device (which may be a personal computer, a server, or a network device, etc.) to execute all or part of the steps of the methods described in various embodiments of the present disclosure. The aforementioned storage media include: U disk, mobile hard disk, read-only memory (read-only memory, ROM), random access memory (random access memory, RAM), magnetic disk or optical disk and other media that can store program code.

An embodiment of the present disclosure further discloses a computer program product. The computer program product includes a computer program stored on a non-transitory computer-readable storage medium. The computer program includes program instructions. When the program instructions are executed by a computer, the computer can execute the methods provided by each of the above method embodiments, including the following blocks.

Block S1: a correspondence between a water temperature and a pressure drop of a target flow line is obtained.

Block S2: a target pressure drop corresponding to a current test water temperature is determined based on the correspondence between the water temperature and the pressure drop of the target flow line.

Block S3: a performance detection result is determined based on a numerical relationship between an actual pressure drop and the target pressure drop.

The target flow line is a flow line between a water inlet end and a water outlet end of the water softening device, and the actual pressure drop is a pressure drop of the target flow line under the current test water temperature.

An embodiment of the present disclosure further provides a non-transitory computer-readable storage medium having a computer program stored thereon. When the computer program is executed by a processor, the methods provided by each of the above method embodiments can be executed, for example, including the following blocks.

Block S1: a correspondence between a water temperature and a pressure drop of a target flow line is obtained.

Block S2: a target pressure drop corresponding to a current test water temperature is determined based on the correspondence between the water temperature and the pressure drop of the target flow line.

Block S3: a performance detection result is determined based on a numerical relationship between an actual pressure drop and the target pressure drop.

The target flow line is a flow line between a water inlet end and a water outlet end of the water softening device, and the actual pressure drop is a pressure drop of the target flow line under the current test water temperature.

The device embodiments described above are only schematic. The units described as separate components may or may not be physically separated. The components shown as units may or may not be physical units, that is, they may be located in one location, or it can be distributed across a plurality of network units. Some or all of the modules can be selected based on actual needs to achieve the purpose of the solution of this embodiment. One of ordinary skill in the art can understand and implement the method without any creative effort.

Through the above description of the embodiments, those skilled in the art can clearly understand that each embodiment can be implemented by software plus a necessary general hardware platform, and of course, it can also be implemented by hardware. Based on this understanding, the above technical solutions can be embodied in the form of software products in essence or in part that contribute to related technologies. The computer software products can be stored in computer-readable storage media, such as ROM/RAM, magnetic disks, optical disk, etc., including a number of instructions to cause a computer device (which can be a personal computer, a server, or a network device, etc.) to execute the methods described in various embodiments or certain parts of the embodiments.

Finally, it should be noted that the above embodiments are only used to illustrate the present disclosure, but not to limit the present disclosure. Although the present disclosure has been described in detail with reference to the embodiments, those skilled in the art should understand that various combinations, modifications, or equivalent replacements of the solutions of the present disclosure do not depart from the scope of the solutions of the present disclosure, and should all be covered within the scope of the claims of the present disclosure.

**Claims**

1. A method for detecting performance of a water softening device, comprising:

   obtaining a correspondence between a water temperature and a pressure drop of a target flow line;
   determining a target pressure drop corresponding to a current test water temperature based on the correspondence between the water temperature and the pressure drop of the target flow line; and
   determining a performance detection result based on a numerical relationship between an actual pressure drop and the target pressure drop,
   wherein the target flow line is a flow line between a water inlet end and a water outlet end of the water softening device, and the actual pressure drop is a pressure drop of the target flow line under the current test water temperature.

2. The method of claim 1, wherein obtaining the correspondence between the water temperature and the pressure drop of the target flow line comprises:
   obtaining the correspondence between the water temperature and the pressure drop of the target flow line by fitting a pre-stored temperature-pressure correspondence table of the target flow line.

3. The method of claim 2, wherein obtaining the correspondence between the water temperature and the pressure drop of the target flow line by fitting the pre-stored temperature-pressure correspondence table of the target flow line comprises:

obtaining a linear regression equation of a water temperature and a pressure drop based on a plurality of reference water temperatures and a plurality of reference pressure drop corresponding to the plurality of reference water temperatures in the temperature-pressure correspondence table; and
determining the correspondence between the water temperature and the pressure drop of the target flow line based on the linear regression equation,
wherein the reference pressure drop is the pressure drop of the target flow line at a corresponding reference water temperature.

4. The method of any one of claims 1 to 3, wherein determining the performance detection result based on the numerical relationship between the actual pressure drop and the target pressure drop comprises:
determining, in accordance with a determination that an absolute value of a difference between the actual pressure drop and the target pressure drop is greater than a preset threshold, a performance detection result is determined as a failure in the pressure drop performance.

5. The method of any one of claims 1 to 4, wherein after determining the performance detection result based on the numerical relationship between the actual pressure drop and the target pressure drop, the method further comprises:

adjusting a simulation model of the target flow line based on the performance detection result,
wherein the adjusting the simulation model of the target flow line comprises at least one of the following:

adjusting the simulation model of the target flow line by adjusting a flow resistance parameter of the target flow line; and
adjusting the simulation model of the target flow line by adjusting a size parameter of a water inlet pipe of the target flow line.

6. The method of claim 5, wherein adjusting the simulation model of the target flow line based on the performance detection result comprises:
performing at least one of the following in accordance with a determination that the actual pressure drop is greater than the target pressure drop:

adjusting the simulation model of the target flow line by decreasing the flow resistance parameter of the target flow line; and
adjusting the simulation model of the target flow line by increasing the size parameter of the water inlet pipe of the target flow line;
performing at least one of the following in accordance with a determination that the actual pressure drop is less than the target pressure drop:

adjusting the simulation model of the target flow line by increasing the flow resistance parameter of the target flow line; and
adjusting the simulation model of the target flow line by decreasing the size parameter of the water inlet pipe of the target flow line.

7. A device for detecting performance of a water softening device, comprising:

an obtaining module, configured to obtain a correspondence between a water temperature and a pressure drop of a target flow line;
a determining module, configured to determine a target pressure drop corresponding to a current test water temperature based on the correspondence between the water temperature and the pressure drop of the target flow line; and
a detecting module, configured to determine a performance detection result based on a numerical relationship between an actual pressure drop and the target pressure drop,
wherein the target flow line is a flow line between a water inlet end and a water outlet end of the water softening device, and the actual pressure drop is a pressure drop of the target flow line under the current test water temperature.

8. An electronic device, comprising a memory, a processor and a computer program stored in the memory and is executable on the processor, wherein when the processor executes the computer program, the processor executes the method for detecting performance of a water softening device of any one of claims 1 to 6.

9. A non-transitory computer-readable storage medium having a computer program stored thereon, wherein when executed by a processor, the computer program executes the method for detecting performance of a water softening device of any one of claims 1 to 6.

10. A computer program product, comprising a computer program, wherein when executed by a processor, the computer program executes the method for detecting performance of a water softening device of any one of claims 1 to 6.

A correspondence between a water temperature and a pressure drop of a target flow line is obtained ⟍S1

A target pressure drop corresponding to a current test water temperature is determined based on the correspondence between the water temperature and the pressure drop of the target flow line ⟍S2

A performance detection result is determined based on a numerical relationship between an actual pressure drop and the target pressure drop ⟍S3

FIG. 1

2.7

Vout=0.35+1.469P

Output voltage Vout (VDC)

Output curve

0.35

0                                                                                1.6

P (inMPa)

FIG. 2

FIG. 3

FIG. 4

Device for detecting performance of a
water softening device

Obtaining module — 501

Determining module — 502

Detecting module — 503

FIG. 5

FIG. 6

| INTERNATIONAL SEARCH REPORT | International application No. |
| --- | --- |
| | **PCT/CN2023/088199** |

**A.  CLASSIFICATION OF SUBJECT MATTER**

G06Q10/06(2023.01)i;  G06F30/20(2020.01)i

According to International Patent Classification (IPC) or to both national classification and IPC

**B.  FIELDS SEARCHED**

Minimum documentation searched (classification system followed by classification symbols)

IPC:  G06Q G06F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 设备, 性能, 检测, 测试, 水温, 压降, 压力, 对应关系, 目标, 实际, 流道, equipment, performance, detect, test, water temperature, pressure drop, correspondence, target, actual, runner, flow

**C.  DOCUMENTS CONSIDERED TO BE RELEVANT**

| Category* | Citation of document, with indication, where appropriate, of the relevant passages | Relevant to claim No. |
| --- | --- | --- |
| PX | CN 115018301 A (FOSHAN SHUNDE MIDEA WATER DISPENSER MANUFACTURING CO., LTD. et al.) 06 September 2022 (2022-09-06) <br> claims 1-10 | 1-10 |
| Y | CN 110763735 A (SHENZHEN H&T DATA RESOURCES AND CLOUD TECHNOLOGY LTD.) 07 February 2020 (2020-02-07) <br> description, paragraphs [0005]-[0038] | 1-10 |
| Y | CN 111124862 A (BEIJING ANTUTU TECHNOLOGY CO., LTD.) 08 May 2020 (2020-05-08) <br> description, paragraphs [0005]-[0056] | 1-10 |
| A | CN 110955201 A (CHINA TOBACCO HENAN INDUSTRIAL CO., LTD.) 03 April 2020 (2020-04-03) <br> entire document | 1-10 |
| A | CN 111637991 A (SHIJIAZHUANG TIEDAO UNIVERSITY) 08 September 2020 (2020-09-08) <br> entire document | 1-10 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **15 June 2023** | **23 June 2023** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/088199** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 112594553 A (PANDA SMART WATER CONSERVANCY CO., LTD.) 02 April 2021 (2021-04-02)<br>       entire document | 1-10 |
| A | CN 113011065 A (SVOLT ENERGY TECHNOLOGY CO., LTD.) 22 June 2021 (2021-06-22)<br>       entire document | 1-10 |
| A | CN 113742153 A (BEIJING BYTEDANCE NETWORK TECHNOLOGY CO., LTD.) 03 December 2021 (2021-12-03)<br>       entire document | 1-10 |
| A | CN 114199451 A (SHENZHEN GANYUE INTELLIGENT CO., LTD.) 18 March 2022 (2022-03-18)<br>       entire document | 1-10 |
| A | US 2019234638 A1 (THE BOARD OF REGENTS OF THE UNIVERSITY OF OKLAHOMA) 01 August 2019 (2019-08-01)<br>       entire document | 1-10 |

Form PCT/ISA/210 (second sheet) (July 2022)

**INTERNATIONAL SEARCH REPORT**
Information on patent family members

International application No.

**PCT/CN2023/088199**

| Patent document cited in search report | | | Publication date (day/month/year) | Patent family member(s) | | | Publication date (day/month/year) |
|---|---|---|---|---|---|---|---|
| CN | 115018301 | A | 06 September 2022 | None | | | |
| CN | 110763735 | A | 07 February 2020 | None | | | |
| CN | 111124862 | A | 08 May 2020 | None | | | |
| CN | 110955201 | A | 03 April 2020 | None | | | |
| CN | 111637991 | A | 08 September 2020 | None | | | |
| CN | 112594553 | A | 02 April 2021 | None | | | |
| CN | 113011065 | A | 22 June 2021 | None | | | |
| CN | 113742153 | A | 03 December 2021 | None | | | |
| CN | 114199451 | A | 18 March 2022 | None | | | |
| US | 2019234638 | A1 | 01 August 2019 | US | 10948209 | B2 | 16 March 2021 |

Form PCT/ISA/210 (patent family annex) (July 2022)

**REFERENCES CITED IN THE DESCRIPTION**

**Patent documents cited in the description**

- CN 202210602602